# EUROPEAN PATENT SPECIFICATION

(11) **EP 2 105 976 B1**
(45) Date of publication and mention of the grant of the patent: **04.06.2014**
(21) Application number: 09004282.1
(22) Date of filing: 25.03.2009
(51) Int. Cl.: H01L 33/50, C25D 13/02, C25D 13/22, B01D 57/02

(54) **Method and apparatus for electrophoretic deposition of a layer comprising phosphor particles of different size on a light emitting diode chip**
Verfahren und Vorrichtung für die elektrophoretische Abscheidung einer Schicht, die Leuchtstoffpartikel unterschiedlicher Größe umfasst auf einem Leuchtdiodenchip
Procédé et dispositif de dépôt électrophorétique d'une couche comprenant des particules phosphorescentes de tailles différentes sur une puce de diode électroluminescente

(30) Priority: 26.03.2008 KR 20080027731
(43) Date of publication of application: 30.09.2009
(73) Proprietor: Seoul Semiconductor Co., Ltd., Seoul 153-801 (KR)
(72) Inventor: Aliyev, Yevgeni, Ansan-si Gyeonggi-do 425-851 (KR)
(74) Representative: Stolmár, Matthias

(56) References cited:
- JP-A- 2004 048 040
- JP-A- 2008 066 365

## Description

### BACKGROUND

### Technical Field

The present disclosure relates to light emitting diodes (LEDs) and, more particularly, to a technique for coating phosphors on an LED chip by electrophoresis.

### Description of the Related Art

One important matter in an LED packaging process is to form a highly efficient optical system using LED chips, phosphors and encapsulation members. In a typical LED package design, the encapsulation member of such an optical system is formed using an encapsulation material such as epoxy resin or silicone gel.

The typical LED package design has the following drawbacks.

Firstly, the typical LED package design provides optical incompatibility of the optical system. As a result, the LED package undergoes Fresnel reflection and total internal reflection loss due to a difference in refractive indices between the LED chips, the phosphors and the encapsulation material (epoxy or silicone).

Secondly, the typical LED package design provides non-uniform radiation of light from an LED. As a result, it is more difficult to obtain a uniform radiation angle of light beams due to volumetric distribution of the phosphors in composites having different thicknesses. Further, white light may have a blue-shifted region (that is, biased toward blue color) and a yellow-shifted region (that is, biased toward yellow color).

Thirdly, the typical LED package design provides a local density variance, which makes it difficult to obtain a permanent optical coordinate.

Fourthly, the typical LED package design causes waste of the phosphors. That is, severe waste of phosphors occurs due to the necessary use of volumetric composite coating.

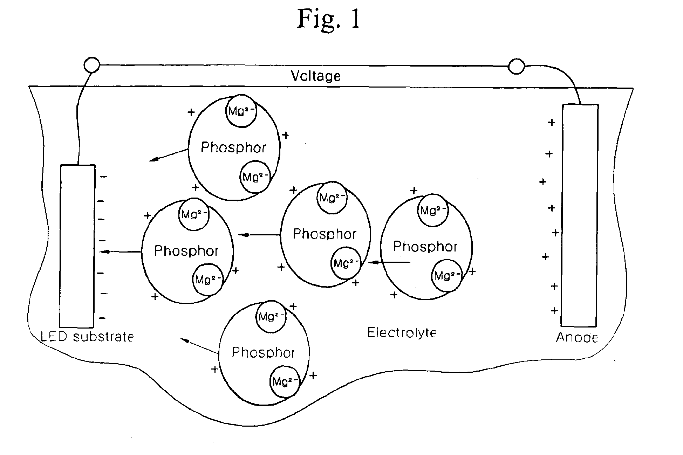

Figure 1 is a diagram illustrating a principle of electrophoresis for use in coating phosphors on an LED chip. Referring to Figure 1, charged phosphors are deposited on an LED substrate which acts as part of a cathode electrode in relation to an anode electrode. In other words, the electrophoresis enables the phosphors to be directly coated at high density to the LED substrate or an LED chip without using a conventional epoxy or silicone matrix and changing an effective refractive index of the phosphors. When a phosphor has a high refractive index, the phosphor also provides high optical output after deposition thereof. The electrophoresis approach is very important for high output power white LEDs that use a large size LED (for example, 1x1mm² or more).

Examples of a method of depositing phosphors by electrophoresis are disclosed in U.S. Patent No. 6,576,488, U.S. Patent No. 6,642,652, U.S. Patent No. 6,686,581 , and U.S. Patent Publication No. 2007/0045761 assigned to Lumlieds Lighting Co. Further, U.S. Patent No. 6,864,110 and No. 6,924,233 to Agilent Technology Inc., and JP 2006-21049 by Nichia Kagaku Kogoy K.K. disclose a method of depositing charged phosphors on a conductive surface of an LED chip by electrophoresis in order to form a uniform phosphor layer producing uniform white light without a colored ring phenomenon.

Fine phosphor particles are used to prepare a homogeneous suspension for electrophoresis deposition. The phosphor particles generally have a size of 2 5 µm in the suspension. An apparatus for electrophoresis deposition includes an agitator which maintains a mixed state of the suspension in a bath. The suspension is sufficiently mixed through, for example, agitation for 24 hours.

The phosphor layer is composed of the fine phosphor particles, but provides relatively inappropriate wavelength conversion efficiency to the phosphor particles. Size reduction of the phosphor particles will lead not only to significant reduction in settlement of the phosphor particles, but also to reduction in wavelength conversion efficiency of the phosphors. Typically, when the size of silicate phosphors is reduced half from 20 µm to 10 µm, the wavelength conversion efficiency is reduced by about 10∼20%. Generally, phosphor particles having a diameter of 15 µm maintain high radiation efficiency, as is known in the art.

Accordingly, large-size phosphor particles can be advantageously used to increase phosphor coating efficiency on one hand, but form an incomplete phosphor coating layer due to a low density of the large-size phosphor particles therein. Therefore, it is necessary to increase the thickness of the phosphor coating layer in order to increase the density of phosphors therein. In this case, however, there are problems, such as excessive consumption of phosphors, high internal absorption and scattering of light by large-size phosphor particles, and the like.

JP 2004 048 040 A discloses a semiconductor light emitting device being provided with a light emitting element; a first fluorescent material absorbing primary light emitted from the light emitting element to emit light of a first wavelength different from the primary light; and a second fluorescent material absorbing the primary light emitted from the light emitting element to emit light of a second wavelength different from the primary light. The first fluorescent material is provided on a first region of the light emitting surface of the light emitting element. The second fluorescent material is provided on a second region, different from the first region, of the light emitting surface of the light emitting element.

### BRIEF SUMMARY

The present disclosure is directed to solve the problems of the related art as described above, and one embodiment includes an improved electrophoresis technique that can improve efficiency of a phosphor coating layer while enhancing quality of the phosphor coating layer and properties of an LED.

According to one aspect, a method of forming a phosphor coating layer on an LED chip by electrophoresis includes: separating phosphor particles in a suspension according to a particle size; and coating the phosphor particles on a surface of the LED chip by sequentially depositing the separated phosphor particles on the surface of the LED chip according to the particle size.

The separating phosphor particles may include allowing the larger ones of the phosphor particles in the suspension to be settled closer to the bottom of a bath containing the suspension by centrifugal or gravity separation process.

According to one embodiment, both the separating phosphor particles and the coating the phosphor particles may be performed inside an electrophoresis bath, in which a cathode electrode and anode electrode are placed, the cathode electrode has the LED chip disposed thereon.

According to one embodiment, the coating the phosphor particles may be performed inside an electrophoresis bath, in which a cathode electrode and an anode electrode are placed, the cathode electrode has the LED chip disposed thereon. The separating phosphor particles may include separating the phosphor particles into a plurality of layers inside a settlement bath such that the phosphor particles can be sequentially supplied from the respective layers to the electrophoresis bath.

According to one embodiment, the coating the phosphor particles may include depositing large-size phosphor particles and then depositing small-size phosphor particles on the surface of the LED chip.

According to one embodiment, the coating the phosphor particles may include depositing middle-size phosphor particles between depositing large-size phosphor particles and depositing small-size phosphor particles. Here, the small-size phosphor particles may be preliminarily deposited before depositing the large-size phosphor particles.

According to one embodiment, the separating phosphor particles may include separating the phosphor particles in the suspension into a plurality of layers inside the electrophoresis bath according to the particle size, and the coating the phosphor particles may further include moving the cathode electrode from one layer to another layer among the plurality of layers.

According to one embodiment, the cathode electrode may be an endless belt-type cathode electrode passing through the electrophoresis bath while continuously circulating, and the method may further include continuously supplying a plurality of LED chips to the electrophoresis bath using the endless belt-type cathode electrode.

According to another aspect, an apparatus for coating phosphors on an LED chip by electrophoresis includes: an electrophoresis bath accommodating a suspension containing phosphor particles separated into a plurality of layers according to a particle size by gravity or centrifugal separation process; a cathode electrode on which the LED chip is placed, the cathode electrode being disposed inside the electrophoresis bath to be located in one of the plurality of layers in the suspension; an anode electrode disposed inside the electrophoresis bath to face the cathode electrode; and an electrode elevator moving upward or downward the cathode electrode from one layer to another layer of the plurality of layers.

According to a further aspect, an apparatus for forming a phosphor coating layer on an LED chip by electrophoresis includes: a settlement bath accommodating a suspension containing phosphor particles separated into a plurality of layers according to a particle size by gravity or centrifugal separation process; an electrophoresis bath having a cathode electrode on which the LED chip is placed and an anode electrode facing the cathode electrode; and a pump and a valve disposed to select one layer of the plurality of layers and to supply the suspension in the selected layer to the electrophoresis bath through pipe lines.

The apparatus may further include a pump and a valve disposed to select one layer of the plurality of layers and to recover the suspension remaining in the electrophoresis bath to the selected layer through pipe lines after deposition of the phosphor particles.

According to one embodiment, the cathode electrode may be an endless belt-type cathode electrode passing through the electrophoresis bath while continuously circulating with a plurality of LED chips disposed thereon. According to one embodiment, the apparatus may further include a plurality of separation baths connected to the settlement bath so as to correspond to the plurality of layers, respectively.

According to yet another aspect, an LED includes a phosphor coating layer formed on a surface of an LED chip by electrophoresis, wherein the phosphor coating layer includes first large-size phosphor particles primarily deposited on the surface of the LED chip and second small-size phosphor particles having a smaller size than the first phosphor particles and deposited on the surface of the LED chip to fill gaps between the first phosphor particles.

According to yet another aspect, an LED includes a phosphor coating layer formed on a surface of an LED chip by electrophoresis, wherein the phosphor coating layer includes preliminary phosphor particles preliminarily deposited on the surface of the LED chip, first large-size phosphor particles having a greater size than the preliminary phosphor particles and deposited on the surface of the LED chip after the preliminary phosphor particles, and second small-size phosphor particles having a smaller size than the first phosphor particles and deposited on the surface of the LED chip to fill gaps between the first phosphor particles.

### BRIEF DESCRIPTION OF THE DRAWINGS

Figure 1 is a diagram illustrating a principle of electrophoresis for use in coating phosphors on an LED chip;
Figure 2 is a graph depicting an exemplary distribution of phosphor particles for use in electrophoresis deposition of phosphors according to the present disclosure;
Figure 3 is a view of a phosphor coating apparatus according to one exemplary embodiment of the present disclosure;
Figure 4 is a view of a method for coating phosphors according to one exemplary embodiment of the present disclosure;
Figure 5 is a view illustrating a modification of the apparatus shown in Figure 3;
Figure 6 is a view of a phosphor coating apparatus according to another exemplary embodiment of the present disclosure; and
Figures 7 and 8 are views of phosphor coating apparatuses according to other exemplary embodiments of the present disclosure.

### DETAILED DESCRIPTION

Exemplary embodiments of the present disclosure will be described in detail with reference to the accompanying drawings.

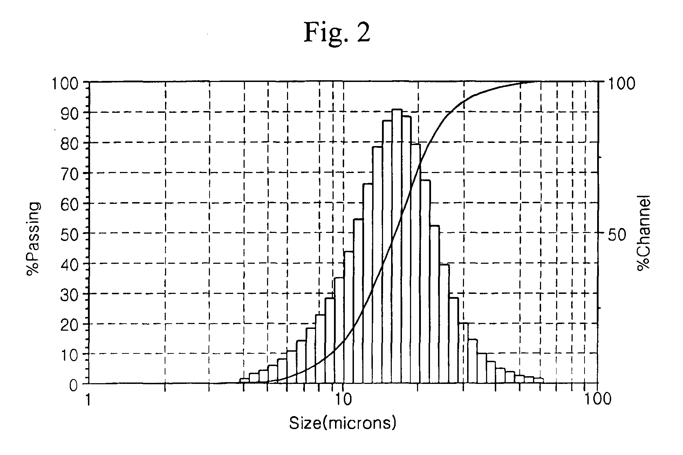

Figure 2 is a graph depicting an exemplary distribution of phosphor particles for use in electrophoresis deposition of phosphors according the present disclosure. To achieve highly efficient deposition of phosphors on an LED chip, a mixture of phosphors having a wide size distribution as shown in Figure 2 may be used.

The phosphor mixture may comprise small-size phosphor particles (1∼5µm) and large-size phosphor particles (10µm or more). As described in the background, the greater the phosphor size, the higher the obtained radiation efficiency (or luminance efficiency).

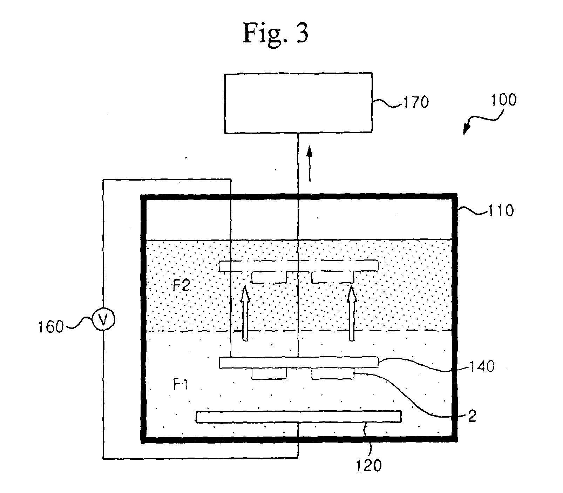

First, as a powdery mixture having a wide size distribution, the phosphor mixture is sufficiently mixed with an electrolyte suspension by agitation. When the mixed suspension is preserved inside an electrophoresis bath for a predetermined duration without contact with an external environment, settlement of the phosphor particles occurs. The settlement of the phosphor particles causes a depthwise distribution of the phosphor particles inside the electrophoresis bath. In other words, the large-size phosphor particles will be settled at a lower location and the small-size phosphor particles will be settled at a higher location in the suspension. Accordingly, it can be considered that plural layers are formed inside the electrophoresis bath. As a simple configuration, the suspension may be divided into two layers as shown in Figure 3. Hereinafter, a method and apparatus for coating phosphors according to one exemplary embodiment of the present disclosure will be described with reference to Figure 3.

In Figure 3, a phosphor coating apparatus 100 of this embodiment includes an electrophoresis bath 110, and an anode electrode 120 and a cathode electrode 140 disposed in the electrophoresis bath 110. The anode and cathode electrodes 120, 140 are connected to an external power source 160. The anode electrode 120 is located at a lower height inside the electrophoresis bath 110, that is, is located closer to the bottom thereof, and the cathode electrode 140 is located above the anode electrode 120 to face the anode electrode 120. Further, an LED chip 2 is positioned on the cathode electrode 140 in a bare chip state or in a state of being mounted on a substrate, which is part of an LED package.

Inside the electrophoresis bath 110, the suspension is separated into a first layer F1, which is located at a lower side of the bath 110 and is mainly composed of phosphor particles having a greater average size, and a second layer F2, which is located at an upper side thereof and is mainly composed of phosphor particles having a smaller average size. The criteria of this separation is not strictly determined but rather is arbitrarily determined by a user. Inside the electrophoresis bath 110, the separation of the phosphor particles into the large-size phosphor particles and the small-size particles may be obtained by gravity or centrifugal separation process.

First, to deposit the large-size phosphor particles on the surface of the LED chip 2, the cathode electrode 140 having the LED chip 2 is located in the first layer F1 which is mainly composed of the large-size phosphor particles. Here, it should be noted that the anode electrode 120 can be also located in the first layer F1 below the cathode electrode 140. In this state, when voltage is applied from the power source 160 to the electrodes, the large-size phosphor particles are charged and moved toward the cathode electrode 140, and are then deposited in a rough arrangement on the surface of the LED chip 2.

Then, for deposition of the small-size phosphor particles, the cathode electrode 140 is shifted to the second layer F2 which is mainly composed of the small-size phosphor particles. In this embodiment, the upward or downward movement of the cathode electrode 140 is performed using an electrode elevator 170 which is operated by electric power, hydraulic pressure or air pressure. Alternatively, the movement of the cathode electrode 140 can be manually achieved without the electrode elevator 170. When voltage is applied from the power source 160 to the electrodes after moving the cathode electrode 140 and the LED chip 2 thereon to the second layer F2, the small-size phosphor particles are deposited on the surface of the LED chip 2 while filling gaps between the previously deposited large-size phosphor particles, that is, holes in an initial phosphor coating layer, thereby improving density of the phosphor coating layer.

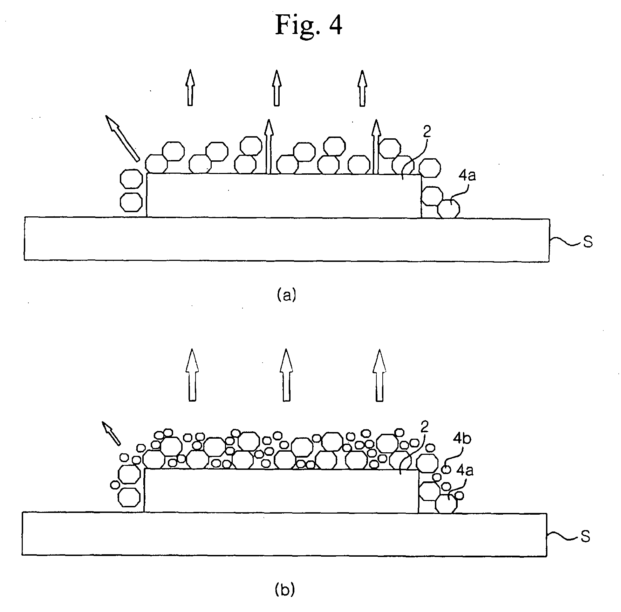

In Figure 4, (a) and (b) show respective steps of the electrophoresis phosphor coating method performed using, for example, the apparatus as shown in Figure 3.

As formed in the first step, that is, in the step of coating large-size phosphor particles shown in Figure 4(a), an initial phosphor coating layer has a low quality. This phosphor coating layer has a number of gaps between large-size phosphor particles 4a, through which a significant amount of blue light passes without being subjected to wavelength conversion into yellow or other colored light. When assuming a white LED including a blue LED chip having the initial phosphor coating layer alone, the white LED will emit white light exhibiting severe blue shift due to a large amount of blue color that does not undergo wavelength conversion. In the second step shown in Figure 4(b), holes of the previously deposited large size phosphor particles (that is, the gaps between the large-size phosphor particles) are filled with small-size phosphor particles 4b, thereby further improving the quality of the phosphor coating layer and a color coordinate. Thus, use of the first and second steps of the method enables the phosphor coating layer for wavelength conversion to be formed with high efficiency and quality. In Figure 4(a) and (b), reference character S indicates the substrate on which the LED chip 2 is mounted, and the substrate may be part of a general LED package.

As the suspension, an exemplary solution may contain water and isopropyl alcohol as a solvent, La(NO₃)₂, Al(NO₃)₂ or other salts as an electrolyte, and a doped yttrium aluminum garnet compound (or, for example, other types of phosphors such as thiogallate, silicate, and the like) as phosphor particles.

The electrophoresis method according to the present disclosure enables easy control in formation of the phosphor coating layer along with a coating rate and time, thereby ensuring that the phosphor coating layer has a uniform thickness. In some embodiments, the phosphor coating layer may have a thickness of about 20∼100µm.

Although not shown in the drawings, an electrically conductive layer may be coated on the surface of the LED chip to provide electrical conductivity to the surface of the LED chip, and the phosphor coating layer is actually deposited on the electrically conductive layer by electrophoresis. The electrical conductivity of the conductive layer is selected to allow the conductive layer to be used as part of the electrodes during electrophoresis without causing short circuit during normal operation of the LED. The conductive layer may be a transparent oxide layer, and more specifically, one oxide selected from the group consisting of indium-tin-oxide (ITO) and antimony-tin-oxide (ATO). In a practical embodiment, the conductive layer is composed of ATO and has a thickness of about 52nm. The conductive layer may be formed by wetting the surface of the LED chip with an ATO solution, followed by drying the surface of the LED chip. Alternatively, a transparent Al-thin film may be formed on the surface of the LED chip by Al-deposition. In this case, the transparent Al-thin film will be subjected to oxidation into a transparent insulator after electrophoresis. After being used to protect other regions on the substrate provided as a coating target during electrolysis, an insulation coating (or mask) may be removed through, for example, typical wet stripping with acetone, mechanical or dry stripping (for example, oxygen plasma stripping). A distance (for example, in the range of 3∼10cm) between the anode electrode and the LED chip can be changed according to distribution of phosphors in the solution and a supply voltage of about 40∼500V. This voltage can also be changed according to the distance between the electrodes.

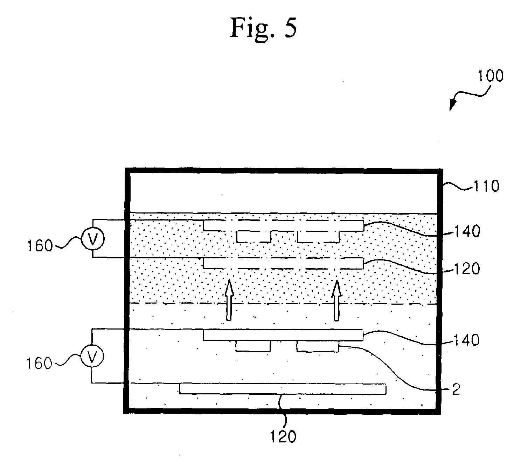

In the configuration of Figure 3, the distance between the electrodes is changed by moving the cathode electrode having the LED chip inside the electrophoresis bath 110 with the anode electrode 120 secured therein. However, as shown in Figure 5, a pair of electrodes comprising the anode electrode 120 and the cathode electrode 140 may be simultaneously moved within the electrophoresis bath 110.

According to the present disclosure, various multilayer phosphor systems may be formed on the LED chip. For example, after deposition of preliminary small-size phosphor particles on an LED chip, large-size phosphor particles and small-size phosphor particles can be sequentially deposited thereon. Further, a multilayer phosphor system can be formed on the LED chip using different kinds of phosphors, which have different sizes and properties.

In the above embodiments, as shown in Figures 3 and 4, the method includes only two steps of depositing the large-size phosphor particles and depositing the small-size phosphor particles in relation to phosphor deposition by electrophoresis.

Next, methods for phosphor deposition by electrophoresis according to other embodiments will be described.

As briefly described above, settlement or sedimentation of the phosphor particles is performed to separate the large-size phosphor particles and the small-size phosphor particles. In particular, a settlement process based on gravity or centrifugal separation process may be used.

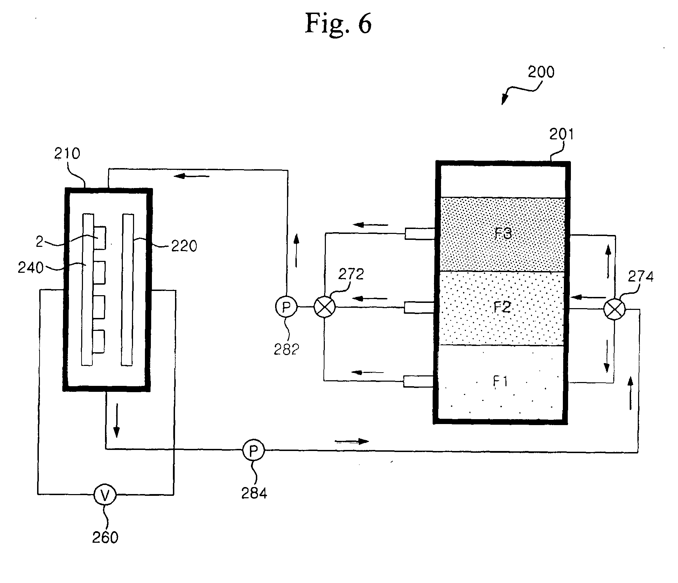

Figure 6 illustrates a phosphor coating apparatus according to another exemplary embodiment of the present disclosure and a coating method using the same.

Referring to Figure 6, a phosphor coating apparatus 200 of this embodiment includes a settlement bath 201, an electrophoresis bath 210, anode and cathode electrodes 220 and 240 disposed inside the electrophoresis bath 210, and a power source 260 for applying voltage to the anode and cathode electrodes 220 and 240.

Inside the settlement bath 201, a phosphor suspension is separated into a plurality of layers (or a plurality of fractions) according to an average size of the phosphor particles by centrifugal or gravity separation. In this embodiment, the plural layers are separated into a first layer F1, a second layer F2, and a third layer F3.

According to this embodiment, the apparatus 200 further includes three pipe lines connected to the settlement bath 201 and corresponding to the first to third layers F1, F2 and F3, and a first valve 272 connected to distal ends of the pipe lines. The first valve 272 allows selection of the suspension of the first to third layers F1, F2 and F3, as supplied from the three pipe lines, and supply of the selected suspension to the electrophoresis bath 210 through a single pipe line. Accordingly, the first valve 272 permits individual supply of large-size phosphor particles in the first layer F1, middle-size phosphor particles in the second layer F2, and small-size phosphor particles in the third layer F3 to the electrophoresis bath 210.

The coating apparatus 200 may further include a second valve 274 which receives the suspension containing the phosphor particles remaining after phosphor coating from the electrophoresis bath 210 through a single pipe line, and which selectively supplies the received suspension to the first, second or third layer F1, F2 or F3 in the settlement bath 201. Further, the coating apparatus 200 may include a first pump 282 which provides a supply flow of the suspension from the settlement bath 201 to the electrophoresis bath 210 via the first valve 272, and a second pump 284 which provides a recovery flow of the suspension from the electrophoresis bath 210 to the settlement bath 201 via the second valve 274. The first and second pumps 282, 284 enable a suspension flow of an optimal speed between the settlement bath 201 and the electrophoresis bath 210.

The anode electrode 220 and the cathode electrode 240 having the LED chip thereon are located inside the electrophoresis bath 210. As in the above embodiments, when voltage is applied from the power source 260, a phosphor coating layer is formed on the surface of the LED chip 2 by electrophoresis. At this time, the phosphor coating layer(s) may be formed differently by adjusting the size of phosphor particles, voltage, distance between the electrodes, and the like. In Figure 6, the electrophoresis bath 210 is illustrated as having a vertical configuration and the anode and cathode electrodes 220, 240 are illustrated as vertically disposed to face each other therein. However, it should be noted that the electrophoresis bath 210 may have a horizontal configuration with the anode and cathode electrodes 220, 240 suitably disposed therein.

Next, one exemplary method of forming a phosphor coating layer on an LED chip by electrophoresis using the apparatus 200 will be described.

First, a suspension is separated into first to third layers F1, F2 and F3 inside the settlement bath 201 by gravity or centrifugal separation process. Then, the suspension containing large-size phosphor particles is supplied from the first layer F1 to the electrophoresis bath 210 by operating the first pump 282 while opening a pipe line between the first layer F1 in the settlement bath 201 and the electrophoresis bath 210 by the first valve 272.

Then, voltage is applied from the power source 260 to the anode and cathode electrodes 220, 240. As a result, the large-size phosphor particles in the suspension are deposited on the surface of the LED chip 2 mounted on the cathode electrode 240 by electrophoresis. After deposition of the large-size phosphor particles in a desired amount, the suspension remaining inside the electrophoresis bath 210 is recovered back to the first layer F1 in the settlement bath 201 by operating the second pump 284 while opening a pipe line between the electrophoresis bath 210 and the first layer F1 in the settlement bath 201 by the second valve 274.

Then, the suspension containing middle-size phosphor particles is supplied from the second layer F2 to the electrophoresis bath 210 by operating the first pump 282 while opening another pipe line between the second layer F2 in the settlement bath 201 and the electrophoresis bath 210 by the first valve 272.

Then, voltage is applied from the power source 260 to the anode and cathode electrodes 220, 240. As a result, the middle-size phosphor particles in the suspension are deposited on the surface of the LED chip 2 mounted on the cathode electrode 240 by electrophoresis. After deposition of the middle-size phosphor particles in a desired amount, the suspension remaining inside the electrophoresis bath 210 is recovered back to the second layer F2 in the settlement bath 201 by operating the second pump 284 while opening another pipe line between the electrophoresis bath 210 and the second layer F2 in the settlement bath 201 by the second valve 274.

Then, the suspension containing small-size phosphor particles is supplied from the third layer F3 to the electrophoresis bath 210 by operating the first pump 282 while opening a third pipe line between the third layer F3 in the settlement bath 201 and the electrophoresis bath 210 by the first valve 272.

Next, voltage is applied from the power source 260 to the anode and cathode electrodes 220, 240. As a result, the small-size phosphor particles in the suspension are deposited on the surface of the LED chip 2 mounted on the cathode electrode 240 by electrophoresis. After deposition of the small-size phosphor particles in a desired amount, the suspension remaining inside the electrophoresis bath 210 is recovered back to the third layer F3 in the settlement bath 201 by operating the second pump 284 while opening a third pipe line between the electrophoresis bath 210 and the third layer F3 in the settlement bath 201 by the second valve 274.

As described above, the phosphor particles may be deposited on the surface of the LED chip 2 in order of upwardly decreasing size from the large-size phosphor particles to the small-size phosphor particles via the middle-size phosphor particles. However, it should be noted that the phosphor particles may be deposited thereon in different orders.

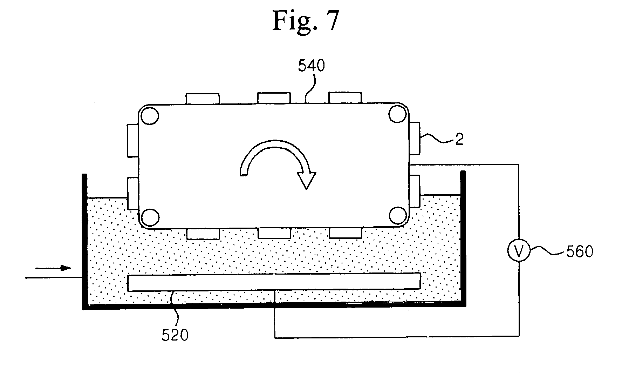

Figure 7 illustrates a phosphor coating apparatus according to a further exemplary embodiment of the present disclosure. In this embodiment, the apparatus may include the same settlement bath, first and second valves, first and second pumps, and pipe lines as those of the above embodiment. Therefore, the same components are omitted in Figure 7.

The apparatus of this embodiment is configured to enable continuous supply of plural LED chips 2 into an electrophoresis bath for electrophoretic deposition in mass production, and employs an endless belt-type cathode electrode 540 which passes through the electrophoresis bath while continuously circulating, instead of the secured cathode electrode of the above embodiments. Here, factors such as voltage, a rotating speed of the belt-type cathode electrode 540, a distance between an anode electrode 520 and the cathode electrode 540, a size of phosphor particles, and the like, can be adjusted to obtain a desired phosphor coating layer on the surfaces of the LED chips 2. A power source 560 is connected to the belt-type cathode electrode 540 and the anode electrode 520.

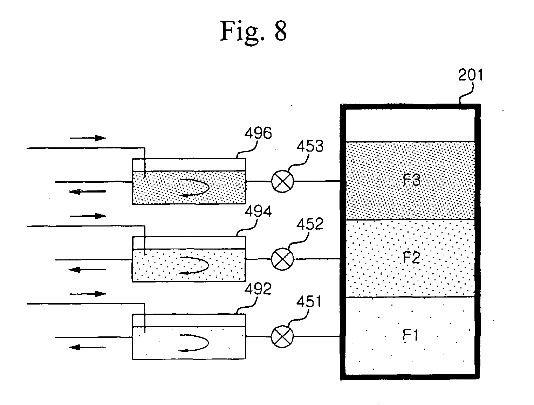

Figure 8 illustrates a phosphor coating apparatus according to yet another exemplary embodiment of the present disclosure. Referring to Fig. 8, a settlement bath 201 is used along with a plurality of separation baths 492, 494 and 496 corresponding to various sizes of phosphor particles. The plural separation baths 492, 494 and 496 are connected to first to third layers F1, F2 and F3 in the settlement bath 201 via a plurality of pipe lines, which are provided with a plurality of on/off valves 451, 452 and 453, respectively. As described above, the large-size phosphor particles are located in the first layer F1, the middle-size phosphor particles are located in the second layer F2, and the small-size phosphor particles are located in the third layer F3.

With the plural separation baths 492, 494 and 496, the apparatus may provide various functions, such as agitation, phosphor filtering, nitrogen gas drying, liquid cleaning, and the like, which can be currently added to a system for electrophoretic deposition of phosphors. These functions are disclosed in U.S. Patent Publication No. 2007/158668.

As apparent from the above description, according to one embodiment, larger phosphor particles can be used to increase phosphor coating efficiency and smaller phosphor particles can be used to fill gaps between the larger phosphor particles, thereby increasing density of the phosphors and providing an LED having a high quality phosphor coating layer formed on the surface of an LED chips.

## Claims

1. A method of forming a phosphor coating layer on an LED chip by electrophoresis, comprising:
separating phosphor particles in a suspension according to a particle size; and
coating the phosphor particles on a surface of the LED chip by sequentially depositing the separated phosphor particles on the surface of the LED chip according to the particle size.

2. The method according to claim 1, wherein the separating phosphor particles comprises allowing the larger ones of the phosphor particles in the suspension to be settled closer to the bottom of a bath containing the suspension by centrifugal or gravity separation process.

3. The method according to claim 2, wherein both the separating phosphor particles and the coating the phosphor particles are performed inside an electrophoresis bath, in which a cathode electrode and an anode electrode are placed, the cathode having the LED chip disposed thereon.

4. The method according to claim 2, wherein the coating the phosphor particles is performed inside an electrophoresis bath, in which a cathode electrode and an anode electrode are placed, the cathode electrode having the LED chip disposed thereon, and the separating phosphor particles comprises separating the phosphor particles into a plurality of layers inside a settlement bath, the phosphor particles being sequentially supplied from the respective layers to the electrophoresis bath.

5. The method according to claim 1, wherein the coating the phosphor particles comprises depositing large-size phosphor particles and then depositing small-size phosphor particles on the surface of the LED chip.

6. The method according to claim 5, wherein the coating the phosphor particles comprises depositing middle-size phosphor particles between the depositing large-size phosphor particles and the depositing small-size phosphor particles.

7. The method according to claim 5, further comprising:
preliminarily depositing the small-size phosphor particles before depositing the large-size phosphor particles.

8. The method according to claim 3, wherein the separating phosphor particles comprises separating the phosphor particles in the suspension into a plurality of layers inside the electrophoresis bath according to the particle size, and the coating the phosphor particles further comprises moving the cathode electrode from one layer to another layer among the plurality of layers.

9. The method according to claim 4, wherein the cathode electrode is an endless belt-type cathode electrode passing through the electrophoresis bath while continuously circulating, the method further comprising:
continuously supplying a plurality of LED chips to the electrophoresis bath using the endless belt-type cathode electrode.

10. An apparatus for forming a phosphor coating layer on an LED chip by electrophoresis, comprising:
an electrophoresis bath for accommodating a suspension containing phosphor particles separated into a plurality of layers according to a particle size by gravity or centrifugal separation process;
a cathode electrode on which the LED chip is placed, the cathode electrode being disposed inside the electrophoresis bath to be located in one of the plurality of layers in the suspension;
an anode electrode disposed inside the electrophoresis bath; and
an electrode elevator moving upward or downward the cathode electrode from one layer to another layer of the plurality of layers.

11. An apparatus for forming a phosphor coating layer on an LED chip by electrophoresis, comprising:
a settlement bath for accommodating a suspension containing phosphor particles separated into a plurality of layers according to a particle size by gravity or centrifugal separation process;
an electrophoresis bath having an anode cathode electrode and a cathode electrode on which the LED chip is placed; and
a pump and a valve disposed to select one layer of the plurality of layers and to supply the suspension in the selected layer to the electrophoresis bath through pipe lines.

12. The apparatus according to claim 11, further comprising:
a pump and a valve disposed to select one layer of the plurality of layers and to recover the suspension remaining in the electrophoresis bath to the selected layer through pipe lines after deposition of the phosphor particles.

13. The apparatus according to claim 11, wherein the cathode electrode is an endless belt-type cathode electrode passing through the electrophoresis bath while continuously circulating with a plurality of LED chips disposed thereon.

14. The apparatus according to claim 11, further comprising:
a plurality of separation baths connected to the settlement bath so as to correspond to the plurality of layers, respectively.

## Patentansprüche

1. Verfahren zur Bildung einer Phosphorschicht auf einem LED-Chip durch Elektrophorese, umfassend:
das Trennen von Phosphorteilchen in einer Suspension entsprechend einer Teilchengröße; und das Aufbringen der Phosphorteilchen auf eine Oberfläche des LED-Chips, in dem die getrennten Phosphorteilchen auf die Oberfläche des LED-Chips gemäß der Teilchengröße sequenziell abgeschieden werden.

2. Verfahren nach Anspruch 1, wobei das Trennen der Phosphorteilchen umfasst, dass die Größeren der Phosphorteilchen in der Suspension sich näher am Boden eines die Suspension enthaltenden Bades durch ein Zentrifugen- oder Schwerkrafttrennverfahren absetzen können.

3. Verfahren nach Anspruch 2, wobei sowohl das Trennen der Phosphorteilchen als auch das Aufbringen der Phosphorteilchen in einem Elektrophoresebad durchgeführt werden, in dem eine kathodische Elektrode und eine anodische Elektrode angebracht sind und auf der Kathode der LED-Chip angeordnet ist.

4. Verfahren nach Anspruch 2, wobei das Aufbringen der Phosphorteilchen innerhalb eines Elektrophoresebads durchgeführt wird, in dem eine kathodische Elektrode und eine anodische Elektrode angebracht sind und auf der kathodischen Elektrode der LED-Chip angeordnet ist, und das Trennen der Phosphorteilchen das Trennen der Phosphorteilchen in eine Vielzahl von Schichten in einem Sedimentationsbad umfasst, wobei die Phosphorteilchen fortlaufend von den entsprechenden Schichten dem Elektrophoresebad zugeführt werden.

5. Verfahren nach Anspruch 1, wobei das Aufbringen der Phosphorteilchen das Abscheiden der großen Phosphorteilchen und anschließend das Abscheiden der kleinen Phosphorteilchen auf der Oberfläche des LED-Chips umfasst.

6. Verfahren nach Anspruch 5, wobei das Aufbringen der Phosphorteilchen das Abscheiden von Phosphorteilchen mittlerer Größe zwischen dem Abscheiden von großen Phosphorteilchen und dem Abscheiden von kleinen Phosphorteilchen umfasst.

7. Verfahren nach Anspruch 5, weiterhin umfassend:
zuerst das Abscheiden der kleinen Phosphorteilchen vor dem Abscheiden der großen Phosphorteilchen.

8. Verfahren nach Anspruch 3, wobei das Trennen der Phosphorteilchen das Trennen der Phosphorteilchen in der Suspension in eine Vielzahl von Schichten in dem Elektrophoresebad entsprechend der Teilchengröße umfasst und das Aufbringen der Phosphorteilchen weiterhin das Bewegen der kathodischen Elektrode von einer Schicht zu einer anderen Schicht von der Vielzahl von Schichten umfasst.

9. Verfahren nach Anspruch 4, wobei die kathodische Elektrode eine Elektrode von der Art eines Endlosbandes ist, die unter kontinuierlichem Umlaufen durch das Elektrophoresebad geführt wird, wobei das Verfahren weiterhin das kontinuierliche Zuführen einer Vielzahl von LED-Chips zu dem Elektrophoresebad unter Verwendung der kathodischen Elektrode von der Art eines Endlosbandes umfasst.

10. Vorrichtung zum Bilden einer Phosphorschicht auf einem LED-Chip durch Elektrophorese, umfassend:
ein Elektrophoresebad zum Aufnehmen einer Phosphorteilchen enthaltenden Suspension, die entsprechend einer Teilchengröße durch Schwerkraft- oder Zentrifugentrennverfahren in eine Vielzahl von Schichten getrennt sind;
eine kathodische Elektrode, auf der LED-Chips angebracht sind, wobei die kathodische Elektrode in dem Elektrophoresebad so angeordnet ist, dass sie in einer der Vielzahl von Schichten in der Suspension liegt;
eine anodische Elektrode, die in dem Elektrophoresebad angeordnet ist; und
einen Elektrodenheber, der die kathodische Elektrode von einer Schicht zu einer anderen Schicht von der Vielzahl von Schichten nach oben oder nach unten bewegt.

11. Vorrichtung zum Bilden einer Phosphorschicht auf einem LED-Chip durch Elektrophorese, umfassend:
ein Sedimentationsbad zum Aufnehmen einer Phosphorteilchen enthaltenden Suspension, die entsprechend einer Teilchengröße durch Schwerkraft- oder
Zentrifugentrennverfahren in eine Vielzahl von Schichten getrennt sind;
ein Elektrophoresebad mit einer anodischen kathodischen Elektrode und einer kathodischen Elektrode auf die der LED-Chip angebracht ist; und
eine Pumpe und ein Ventil, die so angeordnet sind, dass eine Schicht aus der Vielzahl von Schichten ausgewählt wird und die Suspension in der ausgewählten Schicht durch Rohrleitungen dem Elektrophoresebad zugeführt wird.

12. Vorrichtung nach Anspruch 11, weiterhin umfassend:
eine Pumpe und ein Ventil, die so angeordnet sind, dass eine Schicht aus der Vielzahl von Schichten ausgewählt wird und die in dem Elektrophoresebad noch vorhandene Suspension der ausgewählten Schicht durch Rohrleitungen nach Abscheiden der Phosphorteilchen rückgeführt wird.

13. Vorrichtung nach Anspruch 11, wobei die kathodische Elektrode eine Kathode von der Art eines Endlosbandes ist, die mit einer darauf angebrachten Vielzahl von LED-Chips unter kontinuierlichem Umlaufen durch das Elektrophoresebad geführt wird.

14. Vorrichtung nach Anspruch 11, weiterhin umfassend:
eine Vielzahl von Trennbädern, die mit dem Sedimentationsbad so verbunden sind, dass sie der Vielzahl von Schichten entsprechen.

## Revendications

1. Procédé de formation d'une couche de revêtement de phosphore sur une puce de LED par électrophorèse, comprenant :
séparer des particules de phosphore dans une suspension en fonction d'une taille particulaire ; et
enduire les particules de phosphore sur une surface de la puce de LED en déposant de manière séquentielle les particules de phosphore séparées sur la surface de la puce de LED en fonction de la taille particulaire.

2. Procédé selon la revendication 1, dans lequel la séparation de particules de phosphore comprend permettre aux plus grandes des particules de phosphore dans la suspension d'être déposées plus près du fond d'un bain contenant la suspension par un processus de séparation centrifuge ou par gravité.

3. Procédé selon la revendication 2, dans lequel à la fois la séparation de particules de phosphore et l'enduction des particules de phosphore sont réalisées à l'intérieur d'un bain d'électrophorèse dans lequel une électrode de cathode et une électrode d'anode sont placées, la cathode ayant la puce de LED disposée sur elle.

4. Procédé selon la revendication 2, dans lequel l'enduction des particules de phosphore est réalisée à l'intérieur d'un bain d'électrophorèse dans lequel une électrode de cathode et une électrode d'anode sont placées, l'électrode de cathode ayant la puce de LED disposée sur elle, et la séparation de particules de phosphore comprend séparer les particules de phosphore en une pluralité de couches à l'intérieur d'un bain de dépôt, les particules de phosphore étant fournies de manière séquentielle des couches respectives au bain d'électrophorèse.

5. Procédé selon la revendication 1, dans lequel l'enduction des particules de phosphore comprend déposer des particules de phosphore de grande taille, puis déposer des particules de phosphore de petite taille sur la surface de la puce de LED.

6. Procédé selon la revendication 5, dans lequel l'enduction des particules de phosphore comprend déposer des particules de phosphore de taille moyenne entre le dépôt de particules de phosphore de grande taille et le dépôt de particules de phosphore de petite taille.

7. Procédé selon la revendication 5, comprenant en outre :
déposer de manière préliminaire les particules de phosphore de petite taille avant de déposer les particules de phosphore de grande taille.

8. Procédé selon la revendication 3, dans lequel la séparation de particules de phosphore comprend séparer les particules de phosphore dans la suspension en une pluralité de couches à l'intérieur du bain d'électrophorèse en fonction de la taille particulaire, et l'enduction des particules de phosphore comprend en outre déplacer l'électrode de cathode d'une couche à une autre couche parmi la pluralité de couches.

9. Procédé selon la revendication 4, dans lequel l'électrode de cathode est une électrode de cathode de type courroie sans fin passant à travers le bain d'électrophorèse tout en circulant en continu, le procédé comprenant en outre :
fournir en continu une pluralité de puces de LED au bain d'électrophorèse en utilisant l'électrode de cathode de type courroie sans fin.

10. Appareil de formation d'une couche de revêtement de phosphore sur une puce de LED par électrophorèse, comprenant :
un bain d'électrophorèse pour réceptionner une suspension contenant des particules de phosphore séparées en une pluralité de couches en fonction d'une taille particulaire par un processus de séparation par gravité ou centrifuge ;
une électrode de cathode sur laquelle la puce de LED est placée, l'électrode de cathode étant disposée à l'intérieur du bain d'électrophorèse pour être située dans une de la pluralité de couches dans la suspension ;
une électrode d'anode disposée à l'intérieur du bain d'électrophorèse ; et
un élévateur d'électrode déplaçant vers le haut ou vers le bas l'électrode de cathode d'une couche à une autre couche de la pluralité de couches.

11. Appareil de formation d'une couche de revêtement de phosphore sur une puce de LED par électrophorèse, comprenant :
un bain de dépôt pour réceptionner une suspension contenant des particules de phosphore séparées en une pluralité de couches en fonction d'une taille particulaire par un processus de séparation par gravité ou centrifuge ;
un bain d'électrophorèse ayant une électrode d'anode et une électrode de cathode sur laquelle la puce de LED est placée ; et
une pompe et une soupape disposées pour sélectionner une couche de la pluralité de couches et pour fournir la suspension dans la couche sélectionnée au bain d'électrophorèse à travers des conduites.

12. Appareil selon la revendication 11, comprenant en outre :
une pompe et une soupape disposées pour sélectionner une couche de la pluralité de couches et pour récupérer la suspension restant dans le bain d'électrophorèse vers la couche sélectionnée à travers des conduites après dépôt des particules de phosphore.

13. Appareil selon la revendication 11, dans lequel l'électrode de cathode est une électrode de cathode de type courroie sans fin passant à travers le bain d'électrophorèse tout en circulant en continu avec une pluralité de puces de LED disposées sur elle.

14. Appareil selon la revendication 11, comprenant en outre :
une pluralité de bains de séparation connectés au bain de dépôt de manière à correspondre à la pluralité de couches, respectivement.
